# EUROPÄISCHE PATENTSCHRIFT

(11) **EP 0 916 241 B1**
(45) Veröffentlichungstag und Bekanntmachung des Hinweises auf die Patenterteilung: **15.10.2008**
(21) Anmeldenummer: 97930718.8
(22) Anmeldetag: 29.07.1997
(51) Int. Cl.: H05K 9/00

(54) **VERFAHREN ZUM HERSTELLEN EINER ELEKTROMAGNETISCH ABSCHIRMENDEN DICHTUNG**
PROCESS FOR PRODUCING AN ELECTROMAGNETICALLY SCREENING SEAL
PROCEDE POUR PRODUIRE UNE GARNITURE D'ETANCHEITE A EFFET D'ECRAN ELECTROMAGNETIQUE

(30) Priorität: 01.08.1996 DE 19636856
(43) Veröffentlichungstag der Anmeldung: 19.05.1999
(73) Patentinhaber: Kahl, Helmut, 12307 Berlin (DE); Tiburtius, Bernd, 14532 Kleinmachnow (DE)
(72) Erfinder: Kahl, Helmut, 12307 Berlin (DE); Tiburtius, Bernd, 14532 Kleinmachnow (DE)
(74) Vertreter: Ottow, Jens M.
(86) Internationale Anmeldenummer: PCT/IB1997/000952
(87) Internationale Veröffentlichungsnummer: WO 1998/006246

(56) Entgegenhaltungen:
- EP-A- 0 654 962
- WO-A-96/08946
- WO-A-96/22672
- DE-U- 9 404 291

## Beschreibung

### TECHNISCHES GEBIET

Die vorliegende Erfindung bezieht sich auf das Gebiet der Abschirmtechnik. Sie betrifft ein Verfahren zum Herstellen einer elektromagnetisch abschirmenden Dichtung, welche Dichtung ein Substrat mit einem auf dem Substrat angeordneten und mit dem Substrat fest verbundenen Dichtungsstrang aus einem elastischen, elektrisch leitfähigen Dichtungsmaterial umfasst, bei welchem Verfahren ein aushärtbares, elastisches und elektrisch leitfähiges Dichtungsmaterial in pastoser Form in einem vorgegebenen geometrischen Muster auf das Substrat haftend aufgebracht und anschliessend ausgehärtet wird.

Ein solches Verfahren, bei welchem das Dichtungsmaterial per Siebdruck auf das tragende Substrat aufgebracht wird, ist z.B. aus der Druckschrift EP-A2-0 241 192 bekannt.

### STAND DER TECHNIK

Es ist seit langem bekannt, für die Abdichtung von elektromagnetisch abgeschirmten mehrteiligen Gehäusen oder dgl. elastische und gleichzeitig elektrisch leitfähige Dichtungen einzusetzen, welche die Spalte zwischen den Gehäuseteilen sicher verschliessen und einen guten elektrischen Kontakt zwischen den (elektrisch abschirmenden) Gehäuseteilen vermitteln. Für derartige Dichtungen wird neben Schläuchen aus Drahtgewebe oder metallischen Vliesen häufig ein mit elektrisch leitfähigen Füllstoffen (Kohlepartikel, Cu- oder Ag-Teilchen, metallisch beschichtete Kügelchen, versilberte Teilchen oder dgl.) vermengtes Elastomer verwendet, aus welchem im ungehärteten Zustand ein entsprechendes Dichtungsband oder ein Dichtungsstrang geformt wird. Das geformte Band wird anschliessend (durch Wärme, Strahlung, Luftfeuchtigkeit oder dgl.) ausgehartet.

In der US-A-4,659,869 wird eine Abschirmdichtung beschrieben, bei welcher ein Dichtungselement aus einem leitfähigen Elastomer in Form eines Schlauches extrudiert und anschliessend mit einem länglichen Klammerleiste aus Metall verbunden wird. Diese Art der Dichtung ist wegen der Klammerleiste in der Herstellung sehr aufwendig. Darüber hinaus ist sie in der Anwendung sehr unflexibel, weil die Befestigung mit der Klammerleiste eine gerade streifenförmige Blechkante am Gehäuse erfordert, über welche die Klammerleiste geklemmt werden kann. Insbesondere lassen sich mit dieser Technik keine ringförmig geschlossenen Dichtung mit komplizierter Geometrie verwirklichen.

Eine andere Art der Abschirmdichtung ist in der eingangs genannten EP-A2-0 241 192 beschrieben. Hier wird ein flaches Substrat in Form eines ringförmigen Streifens ein- oder beidseitig mittels Siebdruck mit einem oder mehreren Dichtungsverläufen aus einem elektrisch leitenden Elastomer bedruckt. Durch die Siebdrucktechnik lassen sich - anders als im vorher genannten Fall - leicht die unterschiedlichsten Geometrien erzeugen. Der Einsatz der Siebdrucktechnik bringt jedoch auch Nachteile mit sich: Für jede vorgegebene Dichtungsgeometrie müssen zunächst die entsprechend strukturierten Drucksiebe hergestellt werden. Obgleich dies bei grossen Serien keine Einschrankung bedeutet, können Kleinserien mit häufig wechselnden Geometrien auf diese Weise nicht wirtschaftlich hergestellt werden. Weiterhin lassen sich mit der Siebdrucktechnik nur Dichtungsstränge erzeugen, die einen einheitlichen, im wesentlichen rechteckigen Querschnitt haben. Variationen in der Höhe oder der Querschnittsgestalt sind mit dem Siebdruck nicht oder nur sehr schwer realisierbar. Schliesslich ist es auch nicht möglich, die Zusammensetzung des Dichtungsmaterials ortsabhängig zu variieren, um beispielsweise im Dichtungsstrang an manchen Stellen eine anderes Kompressionsverhalten oder dgl. einzustellen.

Eine andere Dichtungstechnik für Abschirmdichtungen, die derartige Einschrankungen nicht kennt, ist von der Anmelderin in einer früheren Patentanmeldung (EP-A1-0 629 114) vorgeschlagen worden. Bei dieser Dichtungstechnik wird der Dichtungsstrang aus einem pastosen, elektrisch leitfähigen Elastomer mittels einer Auftragvorrichtung aus einer Düse in Form einer Raupe direkt auf die eine Dichtfläche des zu dichtenden Gehäuses aufgetragen, wobei die Auftragvorrichtung nach Art eines in mehreren Achsen gesteuerten Roboters die vorgegebene Geometrie der Dichtung nachfährt. Bei dieser auch "form-inplace" genannten Technik wird der Dichtungsstrang so auf der Dichtfläche ausgehärtet, wie er durch die Düse geformt und aufgetragen worden ist. Geeignete Dichtungsmaterialien für dieses Verfahren sind beispielsweise aus den Druckschriften EP-A1-0 643 551 und EP-A1-0 643 552 bekannt.

Die "form-in-place"-Technik ist ausgesprochen flexibel in der Anwendung, lässt sich gleichermassen wirtschaftlich für Gross- und Kleinserien einsetzen und erlaubt es, auch bei sehr kleinen Gehäusen und komplizierten Dichtungsgeometrien auf einfache Weise Dichtungen zu erzeugen. Daruber hinaus können durch eine Steuerung in der Zufuhr des Dichtungsmaterials zur Düse Zusammensetzung und Querschnitt des Dichtungsstranges leicht ortsabhängig variiert werden. Schliesslich ohne weiteres möglich, durch Auftragen mehrerer parallel laufender Einzelstränge, und zwar durch mehrmaliges Auftragen hintereinander oder durch Mehrfachdüsen, komplizierte Querschnitte des Dichtungsstranges und damit spezielle Eigenschaften der Dichtung zu verwirklichen.

Die "form-in-place"-Technik setzt jedoch zwingend voraus, dass zumindest das Gehäuseteil (oder die Leiterplatte), auf dessen (deren) Dichtfläche die Dichtung aufgebracht werden soll, am Ort der Herstellung bereit steht, damit der Dichtungsstrang aufgetragen werden kann. Es wäre Jedoch wünschenswert, die unbestreitbaren Vorteile der "form-in-place"-Technik auch für diejenigen Anwendungsfälle nutzbar zu machen, bei denen die mit der Dichtung auszurüstenden Teile nicht am Ort der Herstellung vorliegen.

### DARSTELLUNG DER ERFINDUNG

Es ist Aufgabe der Erfindung, ein Verfahren zur Herstellung einer Abschirmdichtung anzugeben, welches die Flexibilität des "form-in-place"-Verfahrens aufweist, und gleichzeitig eine Dichtung erzeugt, die unabhangig von dem zu dichtenden Teil gelagert und transportiere sowie unabhangig vom Ort der Herstellung eingesetzt werden kann.

Die Aufgabe wird bei einem Verfahren der eingangs genannten Art durch die Merkmale aus dem Kennzeichen des Anspruchs 1 gelöst. Durch die Ausbildung des Dichtungsstranges auf einem separaten flexiblen Substrat, welches zusammen mit dem Dichtungsstrang die vollstandige Dichtung bildet, können die beiden Prozesse der Herstellung der Dichtung und der Montage der Dichtung entkoppelt werden. Die Dichtung erhalt durch das Substrat als Trager die notwendige mechanische Stabilitat, um separat gelagert und transportiert und zu einem spateren zeitpunkt auf einer Dichtfläche montiert zu werden. Das Substrat kann dabel flexibel den unterschiedlichsten Anforderungen angepasst werden.

Eine erste bevorzugte Ausfuhrungsform des erfindungsgemassen Verfahrens zeichnet sich dadurch aus, dass der Dichtungsstrang aus mehreren Einzelstrangen zusammengesetzt ist, und dass entweder die Einzelstrange des Dichtungsstranges aus einer Düse nacheinander auf das Substrat aufgebracht werden, oder dass die. Einzelstrange des Dichtungsstranges aus mehreren Dusen gleichzeitig auf das Substrat aufgebracht werden. Hierdurch können mit Vorteil sehr unterschiedliche Querschnittsgeometrien erzeugt werden, die entsprechend unterschiedlich Eigenschaften der Dichtung zur Folge haben.

Eine zweite bevorzugte Ausfuhrungsform des Verfahrens nach der Erfindung ist dadurch gekennzeichnet, dass das Dichtungsmaterial auf ein vollflachiges Substrat aufgebracht wird, und dass anschliessend aus dem vollflächigen Substrat die mit dem Dichtungsstrang bedeckten Bereiche herausgetrennt werden und die Dichtung bilden. Durch die Beschrankung des Substrats auf die vom Dichtungsstrang bedeckten Bereiche nimmt die Dichtung weniger Platz ein.

Gemass weiterer bevorzugter Ausführungsformen wird als substrat eine flexible Folie verwendet, die entweder elektrisch isolierend ist, und insbesondere aus einem Kunststoffmaterial besteht, oder elektrisch leitend ist, und insbesondere eine Metallfolie oder eine ein- oder beidseitig metallisierte Kunststoffolie ist, oder es wird als Substrat ein Gewebe, Gitter oder Netz verwendet, welches entweder elektrisch isolierend ist, und insbesondere aus einem Kunststoffmaterial bestht, oder elektrisch leitend ist, und insbesondere ein Metallgewebe, -gitter oder -netz ist, oder ein Faservlies. Die Substrate in Form von Folien, Geweben, Gittern, Netzen und Vliesen lassen sich besonders gut schwierigen Geometrien anpassen.

Eine andere bevorzugte Ausführungsform des erfindungsgemasse Verfahrens ist dadurch gekennzeichnet, dass ein Substrat verwendet wird, welches im Bereich des Dichtungsstranges Aussparungen aufweist, durch welche der Dichtungsstrang in Kontakt mic einer Flache kommen kann, auf welcher das die Dichtung mit dem Substrat aufliegt. Derartige "gelochte" Substrate, wie z.B. Lochbleche, grobe Gewebe, Netze, Gitter oder dgl., ermöglichen eine direkte elektrische Verbindung des Dichtungsstranges mit der oberen und unteren Dichtfläche.

Weitere Ausführungsformen ergeben sich aus den abhangigen Anspruchen.

### KURZE ERLAUTERUNG DER FIGUREN

Die Erfindung soll nachfolgend anhand von Ausfuhrungsbeispielen im Zusammenhang mit der Zeichnung naher erlautert werden.
Es zeigen
- Fig. 1: in perspektivischer Ansicht ein beispielhaftes vollflachiges Substrat fur das Verfahren nach der Erfindung;
- Fig. 2: das Auftragen eines Dichtungsstranges auf das Substrat nach Fig. 1 gemass einem bevorzugten Ausfuhrungsbeispiel der Erfindung;
- Fig. 3: den im Vorgang nach Fig. 2 fertig aufgebrachten Dichtungsstrang;
- Fig. 4: das beispielhafte Heraustrennen der mit dem Dichtungsstrang nach Fig. 3 bedeckten Substratbereiche aus dem vollflächigen Substrat;
- Fig. 5: die durch die Schritte gemass Fig. 2 bis 4 hergestellte einsatzbereite Dichtung;
- Fig. 6: die Anwendung der Dichtung nach Fig. 5 zur EMI-Abdichtung eines aus Ober- und Unterteil bestehenden beispielhaften Gehäuses;
- Fig. 7: in der Draufsicht von oben eine nach dem erfindungsgemassen Verfahren hergestellte Dichtung mit einem gitternetzformigen Substrat, wobei die Netzlinien parallel zum Dichtungsstrang orientiert sind;
- Fig. 8: in der Draufsicht von oben eine nach dem erfindungsgemassen Verfahren hergestellte Dichtung mit einem gitternetzformigen Substrat, wobei die Netzlinien schiefwinklig zum Dichtungsstrang orientiert sind;
- Fig. 9a,b: eine zu Fig. 7 vergleichbare Dichtung in der Seitenansicht, bei welcher Dichtung sich der Dichtungsstrang im ungedruckten Zustand (Fig. 9a) oberhalb des Substrats befindet und erst im gedruckten Zustand (Fig. 9b) durch das Substrat hindurch mit der unteren Dichtungsflache in Kontakt tritt; und
- Fig. 10: eine zu Fig. 9 vergleichbare Dichtung, bei welcher der Dichtungstrang bereits im unbelasteten Zustand durch das Substrat hindurch Kontakt nacht.

### WEGE ZUR AUSFUHRUNG DER ERFINDUNG

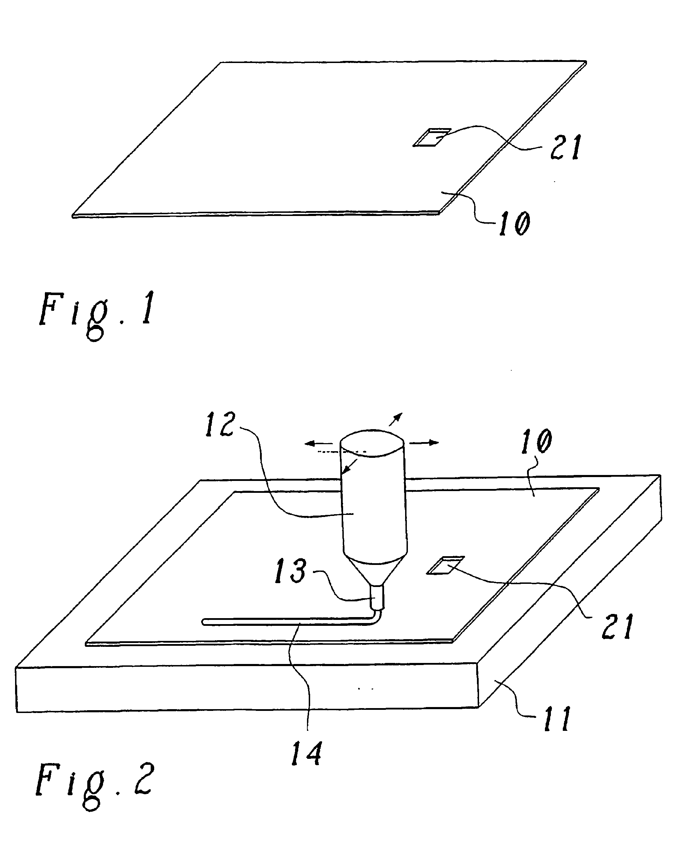

Das erfindungsgemasse Verfahren geht aus von einem dunnen, vorzugsweise ebenen Substrat 10, wie es in Fig. 1 wiedergegeben ist. Das Substrat 10 kann an vorgegebenen Stellen eine oder mehrere Aussparungen 21 aufweisen, auf deren Bedeutung weiter unten noch eingegangen wird. Während in Fig. 1 nur eine beispielhafte Aussparung 21 eingezeichnet ist, ist es ohne weiteres denkbar, dass beim Substrat 10 über die gesamte Substratflache gleichmassig verteilt Aussparungen angeordnet sind, wie dies z.3. bei einem Lochblech oder einen gelochten Folie der Fall ist.

Das Substrat 10 ist flexibel ausgebildet. Es kann elektrisch leitend oder auch nichtleitend gewahlt werden. Als Substrat kommen vorzugsweise Folien, Gewebe, Gitter, Netze oder Faservliese in Betracht, die entweder aus Metall (Metallfolien oder Metallgewebe, -gitter oder -netze, oder Metallvlies) oder aus einem (oder mehreren) ggf. auch metallisierten Kunststoffen bestehen konnen.

Zum Aufbau der Dichtung wird nun das (vollflachige) Substrat 10 gemass Fig. 2 auf eine geeignete stabile Unterlage 11 gelegt und dort ausreichend fixiert. Mit einer Auftragvorrichtung 12, die relativ zur Unterlage 11 bzw. zum darauf liegenden Substrat 10 in mehreren Achsen numerisch gesteuert bewegt werden kann, wird nun aus einer Düse 13 unter Druck ein elastisches, elektrisch leitendes, in unausgehartetem Zustand pastoses Dichtungsmaterial in Form eines raupenartigen Dichtungsstranges 14 auf das Substrat 10 aufgebracht. Die Auftragvorrichtung 12 fährt dabei automatisch ein vorgegebenes geometrisches Muster nach, welches dem Verlauf der spateren Dichtung entspricht. Die relative Bewegung der Auftragvorrichtung 12 zur Unterlage 11 bzw. zum Substrac 10 kann dabei wahlweise dadurch erreicht werden, dass die Unterlage 11 ortsfest gehalten und die Auftragvorrichtung 12 daruber hinweg bewegt wird, oder dass die Auftragvorrichtung 12 ortsfest gehalten und die Unterlage 11 mit dem Substrat 10 unter der Auftragvorrichtung 12 hinweg bewegt wird. Als Auftragvorrichtung 12 kommt eine Vorrichtung in Betracht, wie sie beispielsweise in der Europäischen Patentanmeldung EP-A1-0 629 114 der Anmelderin beschrieben ist. Als Dichtungsmaterial für die Bildung des Dichtungsstranges kommen vorzugsweise mit elektrisch leitendem Füllmaterial vermengte Elastomere zur Anwendung, wie sie in der Zusammensetzung beispielsweise in den Druckschriften EP-A1-0 643 551 und EP-A1-0 643 552 beschrieben sind. Die Aushärtung, die zugleich mit einem dauerhaften Anhaften an dem Substrat 10 verbunden ist, kann auf verschiedene Weise erfolgen und insbesondere durch Wärme oder durch Einwirkung der Luftfeuchtigkeit bewirkt werden.

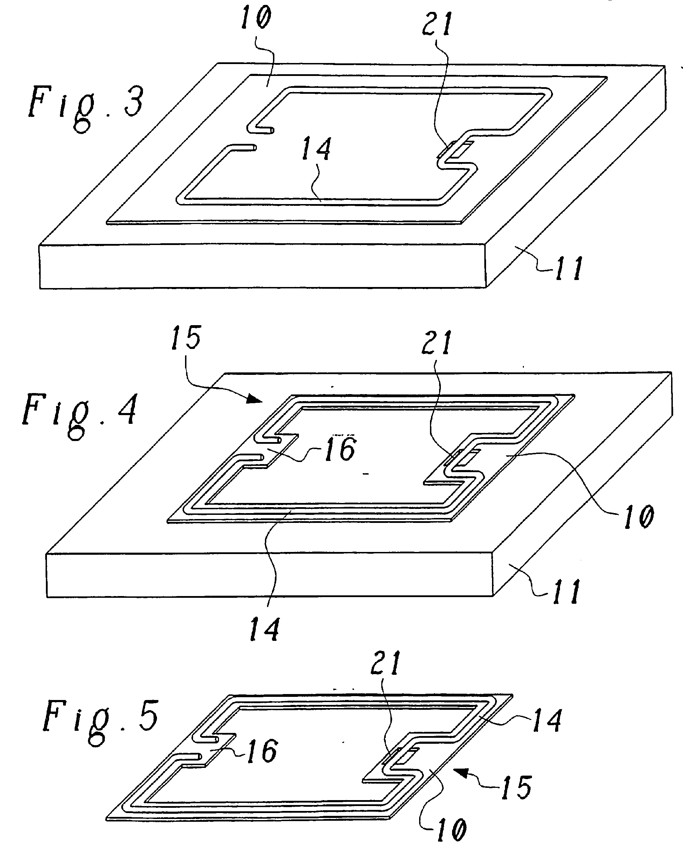

Ist der Auftragvorgang abgeschlossen, ergibt sich der in Fig. 3 gezeigte Zustand, in welchem das Substrat 10 mit einem vollständig ausgebildeten (offen oder geschlossen ringformigen, mäanderförmigen, labyrinthartigen oder andersgestaltigen) Dichtungsstrang 14 bedeckt ist. In einem weiteren (optionalen) Schritt wird nun gemäss Fig. 4 derjenige Bereich des Substrats 10, welcher von dem Dichtungsstrang 14 bedeckt ist, aus dem vollflächigen Substrat 10 ausgestanzt oder beispielsweise mittels eines Laserstrahls oder eines Hochdruckwasserstrahls ausgeschnitten, um schliesslich die fertige Dichtung 15 zu ergeben, welche aus dem (ausgeschnittenen) Substrat 10 und dem fest darauf haftenden Dichtungsstrang 14 besteht. Es ist ebensogut auch möglich, dass in Umkehrung der Reihenfolge zunächst aus einem vollflächigen Substrat die Bereiche herausgetrennt werden, welche den späteren Dichtungsstrang tragen sollen, und dass erst anschliessend zur Bildung der Dichtung das Dichtungsmaterial auf die herausgetrennten Bereiche aufgebracht wird.

Es kann dabei insbesondere von Vorteil sein, wenn das ausgeschnittene Substrat 10 an einer Stelle, wo der Dichtungsstrang anwendungsbedingt eine Unterbrechung 16 aufweist, durchgehend ausgebildet ist. Damit wird ein sicheres und vereinfachtes Handling der Dichtung auch im Bereich der "losen" Enden des Dichtungsstranges 14 erzielt. Die fertige Dichtung 15 kann anschliessend von der Unterlage 11 abgenommen werden und steht in der in Fig. 5 gezeigten Form zum Transport, zur Lagerung oder zur direkten Anwendung zur Verfügung.

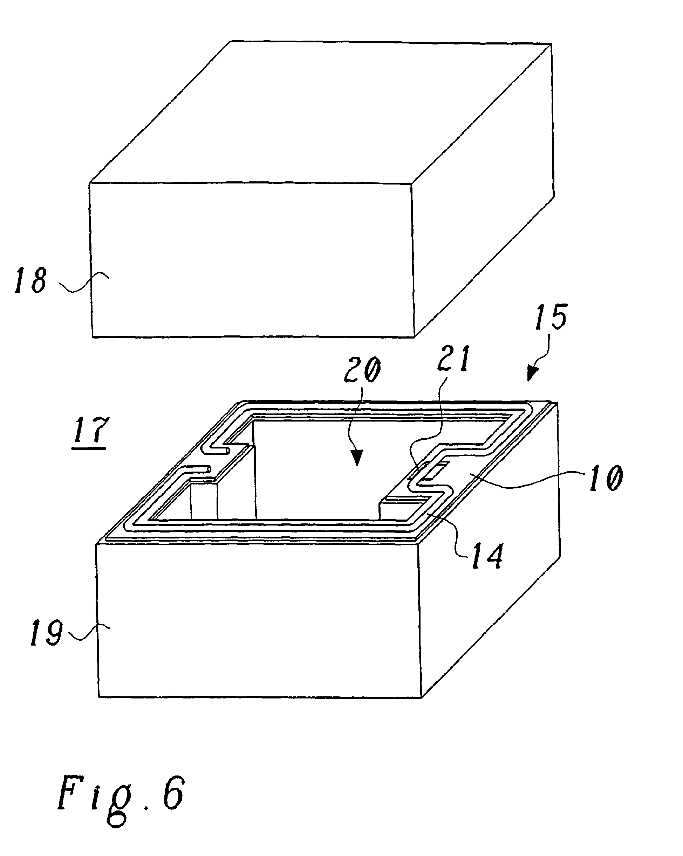

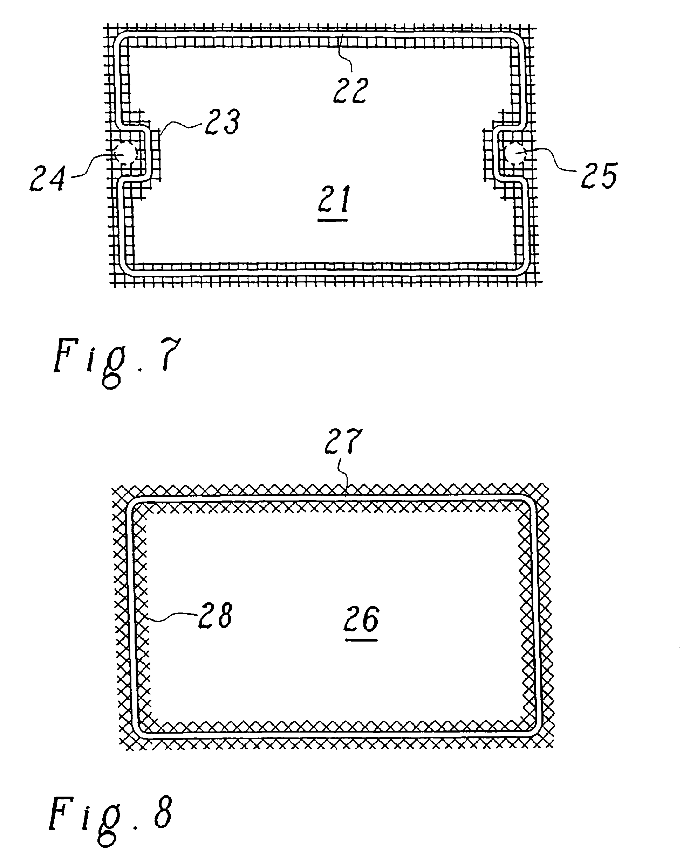

Eine beispielhafte Anwendung bei einem elektrisch abschirmenden Gehäuse 17, welches aus einem Gehäuseoberteil 18 und einem Gehäuseunterteil 19 besteht und einen abzuschirmenden Innenraum 20 umschliesst, ist in Fig. 6 gezeigt. Die Dichtung 15 gemäss Fig. 5, die in ihrer ausgeschnittenen Randkontur vorzugsweise der Dichtungsfläche des Gehauses 17 angepasst ist, wird beispielsweise auf die Dichtungsfläche des Gehäuseunterteils 19 lose aufgelegt oder aufgeklebt. Eine Justierung und/oder mechanische Fixierung kann dabei dadurch erreicht werden, dass - wie weiter unten im Zusammenhang mit Fig. 7 beschrieben - im Substrat 10 Oeffnungen (24, 25 in Fig. 7) vorgesehen sind, mit denen das Substrat 10 über entsprechende auf der unteren Dichtungsfläche angebrachte Pfosten oder Pins geschoben werden kann. Das Gehäuseoberteil 18, welches über eine entsprechende Dichtungsfläche verfügt, wird dann auf die Dichtung 15 aufgesetzt, wobei der Dichtungsstrang 14 zusammengedrückt wird und das Gehäuse 17 elektromagnetisch abdichtet. Im Bereich der Ausnehmung 21 wird der Dichtungsstrang 14 dabei durch die Ausnehmung 21 hindurch auf die direkt unter dem Substrat 10 befindliche Dichtungsfläche des Gehäuseunterteils gepresst, so dass der Dichtungsstrang im Bereich der Aussparung 21 mit beiden Gehäuseteilen 18, 19 elektrischen Kontakt macht (Durchkontaktierung). Dies ist insbesondere von Bedeutung, wenn als Substrat 10 eine isolierende Folie oder Platte verwendet wird, Ober- und Unterteil aber elektrisch miteinander verbunden sein sollen.

Die Durchkontaktierung zwischen Ober- und Unterteil lässt sich besonders einfach und grossflächig erreichen, wenn gemäss Fig. 7-10 als Substrat für die Dichtung ein grobmaschiges Gewebe, Gitter oder Netz (aus Kunststoff oder Metall) verwendet wird. Im Ausführungsbeispiel der Fig. 7 wird die Dichtung 21 durch einen Dichtungsstrang 22 gebildet, der auf einem gitterförmigen Substrat 23 aufgebracht ist. Der Dichtungsstrang 22 verläuft dabei parallel zu den Gitterlinien. Sind die Gitterlinien selbst in Längsrichtung nicht oder nur schwer dehnbar, wird durch die parallele Orientierung erreicht, dass der Dichtungsstrang 22 praktisch nicht gedehnt werden kann und damit gegen eine Ueberdehnung geschützt ist.

In dem Substrat 23 sind beispielhaft zwei kreisrunde (z.B. gestanzte oder geschnittene) Oeffnungen 24 und 25 vorgesehen, um welche herum der Dichtungsstrang 22 geführt ist. Die Dichtung 21 kann bei der Montage mit den Oeffnungen 24, 25 über entsprechende Pfosten oder Pins auf dem Gehäuseunterteil bwz. auf der unteren Dichtungsfläche, die gleichzeitig dem vereinfachten Zusammenfügen der Gehäuseteile dienen, geschoben werden. Hierdurch wird einerseits eine automatische Justierung der Dichtung 21 relativ zum Gehäuse erreicht. Andererseits kann bei entsprechender Gestaltung der Pfosten bzw. Pins auch eine einrastende mechanische Fixierung der Dichtung 21 auf der unteren Dichtungsfläche erzielt werden.

Ein weiteres Beispiel für eine Dichtung nach der Erfindung ist in Fig. 8 wiedergegeben. Die Dichtung 26 umfasst einen geschlossenen Dichtungsstrang 27, der ebenfalls auf ein gitterförmiges Substrat 28 aufgebracht ist. In diesem Fall sind jedoch die Gitterlinien schiefwinklig zum Dichtungsstrang 27 orientiert. Lassen sich die Gitterlinien selbst verbiegen, kann bei dieser Orientierung das Substrat 28 und damit der Dichtungstrang in Strangrichtung gedehnt werden. Auf diese Weise kann die Dichtung 26 an unterschiedliche Geometrien leichter angepasst werden.

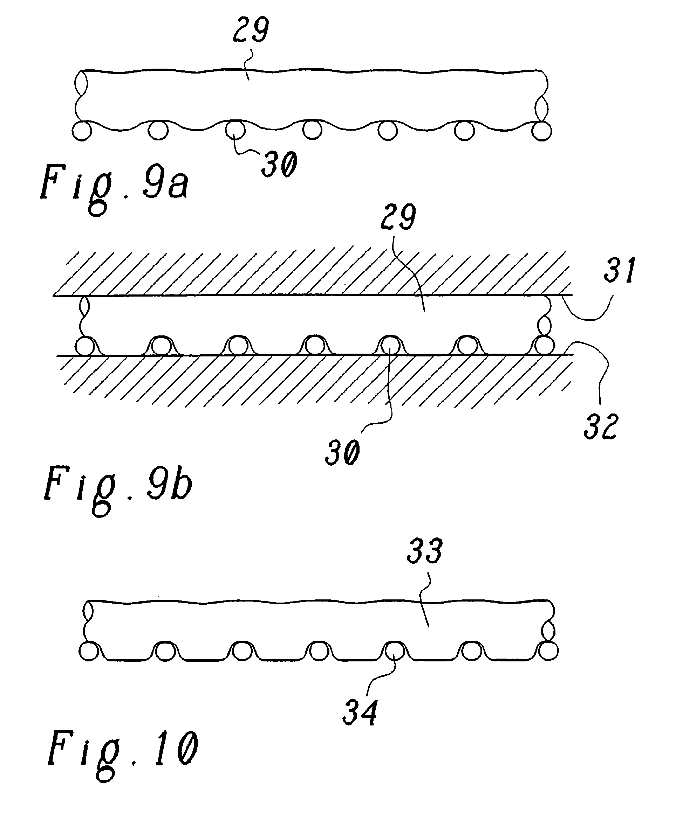

Bei der Verwendung von gitterformigen Substraten hangt es massgeblich von der Dicke des Substrats (Dicke der Fäden oder Gitterstäbe), dem Gitterabstand bzw. der Maschenweite, und von der Viskosität der Dichtungsmasse beim Auftragen ab, ob der fertige Dichtungsstrang durch das Substrat hindurch nach unten Kontakt machen kann oder nicht. In Fig. 9a ist in der Seitenansicht ein Fall gezeigt, bei dem der Dichtungsstrang 29 nach dem Aushärten (im unbelasteten Zustand) weitgehend oberhalb des gitterformigen Substrats 30 liegt, ohne durch das Substrat 30 hindurch nach unten zu reichen. Erst im Anwendungsfall (Fig. 9b) wird durch das Zusammenpressen des Dichtungsstranges 29 zwischen den beiden Dichtungsflächen 31 und 32 erreicht, dass der (elastische) Dichtungsstrang 29 durch das Substrat 30 hindurch auf die untere Dichtungsfläche 32 gedrückt wird und so weitgehend den Spalt zwischen oberer und unterer Dichtungsfläche 31 bzw. 32 schliesst.

Werden der Gitterabstand bzw. die Maschenweite des Substrats grösser gewählt oder die Viskosität der Dichtungsmasse beim Auftragen verringert, ergibt sich eine Dichtung gemass Fig. 10, bei welcher der Dichtungsstrang 33 bereits im unbelasteten Zustand durch die Maschen des gitterförmigen Subtrats 34 nach unten hindurchreicht. Auf diese Weise kann bei einem nichtleitenden Substrat (Kuststoffgewebe oder -gitter) der störende Einfluss des Substrats auf die Abschirmeigenschaften auf ein Minimum reduziert werden.

Insgesamt ergibt sich mit dem erfindungsgemässen Verfahren eine Abschirmdichtung, welche sich durch folgende Vorteile auszeichnet:
- einfache und preiswerte Herstellung
- flexibel in der Anwendung auch bei sehr komplexen und filigranen Geometrien
- Substrat (Trägermaterial) kann in weiten Grenzen frei gewählt und auf den jeweiligen Anwendungsfall optimal abgestimmt werden
- einfaches und sicheres Handling der fertigen Dichtung
- Herstellen der Dichtung unabhangig vom Gehäuse.

### BEZEICHNUNGSLISTE

- 10: Substrat
- 11: Unterlage
- 12: Auftragvorrichtung
- 13: Düse
- 14: Dichtungsstrang
- 15: Dichtung
- 16: Unterbrechung
- 17: Gehäuse
- 18: Gehäuseoberteil
- 19: Gehäuseunterteil
- 20: Innenraum (Gehäuse)
- 21,26: Dichtung
- 22,27: Dichtungsstrang
- 23,28: Substrat (gitter- bzw. netzförmig)
- 29,25: Oeffnung
- 29,33: Dichtungsstrang
- 30,34: Substrat (gitter- bzw. netzförmig)
- 31.32: Dichtungsfläche

## Patentansprüche

1. Verfahren zum Herstellen einer Transportfähigen, elektromagnetisch abschirmenden Dichtung (15, 21, 26) für ein zu dichtendes Teil, welche Dichtung (15, 21, 26) separat von dem zu dichtenden Teil gelagert und transportiert und zu einem späteren Zeitpunkt auf einer Dichtfläche des zu dichtenden Teils montiert werden kann, und welche Dichtung (15, 21, 26) ein Substrat (10, 23, 28, 30, 34) mit einem auf dem Substrat (10, 23, 28, 30, 34) angeordneten und mit dem Substrat (10, 23, 28, 30, 34) fest verbundenen Dichtungsstrang (14, 22, 27, 29, 33) aus einem elastischen, elektrisch leitfähigen Dichtungsmaterial umfasst, bei welchem Verfahren ein aushärtbares, elastisches und elektrisch leitfähiges Dichtungsmaterial in pastöser Form in einem vorgegebenen geometrischen Muster auf das Substrat (10, 23, 28, 30, 34) haftend aufgebracht und anschliessend ausgehärtet wird, **dadurch gekennzeichnet, dass** ein flexibles Substrat (10, 23, 28, 30, 34) verwendet wird, dass das Substrat (10, 23, 28, 30, 34) auf eine geeignete stabile Unterlage (11) gelegt und dort ausreichend fixiert wird, dass das Dichtungsmaterial mittels einer relativ zum Substrat (10, 23, 28, 30, 34) beweglichen, das vorgegebene geometrische Muster nachfahrenden Auftragvorrichtung (12) in Form eines Dichtungsstranges (14, 22, 27, 29, 33) aus einer Düse (13) auf das Substrat (10, 23, 28, 30, 34) aufgebracht und als Dichtungsstrang (14, 22, 27, 29, 33) ausgehärtet wird, und dass die fertige Dichtung (15, 21, 26) zum Transport, zur Lagerung oder zur direkten Anwendung von der Unterlage (11) abgenommen wird.

2. Verfahren nach Anspruch 1, **dadurch gekennzeichnet, dass** der Dichtungsstrang (14, 22, 27, 29, 33) aus mehreren Einzelstrangen zusammengesetzt ist.

3. Verfahren nach Anspruch 2, **dadurch gekennzeichnet, dass** die Einzelstrange des Dichtungsstranges (14, 22, 27, 29, 33) aus einer Düse nacheinander auf das Substrat (10, 23, 23, 30, 34) aufgebracht werden.

4. Verfahren nach Anspruch 2, **dadurch gekennzeichnet, dass** die Einzelstränge des Dichtungsstranges (14, 22, 27, 29, 33) aus mehreren Dusen gleichzeitig auf das Substrat (10, 23, 28, 30, 34) aufgebracht werden.

5. Verfahren nach einem der Ansprüche 1 bis 4, **dadurch gekennzeichnet, dass** als Dichtungsmaterial ein mit elektrisch leitenden Füllstoffen vermengtes Elastomer verwendet wird.

6. Verfahren nach einem der Ansprüche 1 bis 5, **dadurch gekennzeichnet, dass** das Dichtungsmaterial auf ein vollflächiges Substrat (10, 23, 28, 30, 34) aufgebracht wird, und dass anschliessend aus dem vollflächigen Substrat (10, 23, 28, 30, 34) die mit dem Dichtungsstrang (14, 22, 27, 29, 33) bedeckten Bereiche herausgetrennt werden und die Dichtung (15, 21, 26) bilden.

7. Verfahren nach Anspruch 6, **dadurch gekennzeichnet, dass** die mit dem Dichtungsstrang (14, 22, 27, 29, 33) bedeckten Bereiche aus dem vollflächigen Substrat (10, 23, 28, 30, 34) durch Stanzen herausgetrennt werden.

8. Verfahren nach Anspruch 6, **dadurch gekennzeichnet, dass** die mit dem Dichtungsstrang (14, 22, 27, 29, 33) bedeckten Bereiche aus dem vollflächigen Substrat (10, 23, 28, 30, 34) durch Schneiden, insbesondere Laserschneiden oder Wasserstrahlschneiden, herausgetrennt werden.

9. Verfahren nach einem der Ansprüche 1 bis 5, **dadurch gekennzeichnet, dass** aus einem vollflächigen Substrat (10, 23, 28, 30, 34) die Bereiche herausgetrennt werden, welche den späteren Dichtungsstrang (14, 22, 27, 29, 33) tragen sollen, und dass zur Bildung der Dichtung (15, 21, 26) das Dichtungsmaterial auf die herausgetrennten Bereiche aufgebracht wird.

10. Verfahren nach einem der Ansprüche 1 bis 9, **dadurch gekennzeichnet, dass** als Substrat (10) eine flexible Folie verwendet wird.

11. Verfahren nach Anspruch 10, **dadurch gekennzeichnet, dass** die Folie elektrisch isolierend ist, und insbesondere aus einem Kunststoffmacenal besteht.

12. Verfahren nach Anspruch 10, **dadurch gekennzeichnet, dass** die Folie elektrisch leitend ist, und insbesondere eine Metallfolie oder eine ein- oder beidseitig metallisierte Kunststoffolie ist.

13. Verfahren nach einem der Anspruche 1 bis 9, **dadurch gekennzeichnet, dass** als Substrat (23, 28, 30, 34) ein Gewebe, Gitter oder Netz verwendet wird.

14. Verfahren nach Anspruch 13, **dadurch gekennzeichnet, dass** das Gewebe, Gitter oder Netz elektrisch isolierend ist, und insbesondere aus einem Kunststoffmaterial besteht.

15. Verfahren nach Anspruch 14, **dadurch gekennzeichnet, dass** das Gewebe, Gitter oder Netz elektrisch leitend ist, und insbesondere ein Metallgewebe, -gitter oder -netz ist.

16. Verfahren nach einen der Ansprüche 1 bis 9, **dadurch gekennzeichnet, dass** als Substrat (10) ein Faservlies verwendet wird.

17. Verfahren nach einem der Ansprüche 1 bis 16, **dadurch gekennzeichnet, dass** ein Substrat (10) verwendet wird, welches im Bereich des Dichtungsstranges (14) Aussparungen (21) aufweist, durch welche der Dichtungsstrang (14) in Kontakt mit einer Fläche kommen kann, auf welcher das die Dichtung (15) mit dem Substrat (10) aufliegt.

18. Verfahren nach einem der Ansprüche 1 bis 17, **dadurch gekennzeichnet, dass** in dem Substrat (23) Oeffnungen (24, 25) zur Justierung und/oder Fixierung der Dichtung (21) auf einer Dichtungsflache vorgesehen werden.

## Claims

1. A method for manufacturing a transportable, electromagnetically shielding seal (15, 21, 26) for a part to be sealed, said seal (15, 21, 26) being stored and transported separately from the part to be sealed, and being able to be assembled at a later point in time on a sealing surface of the part to be sealed, and said seal (15, 21, 26) comprising a substrate (10, 23, 28, 30, 34) with a sealing bead (14, 22, 27, 29, 33) of an elastic, electrically conductive sealing material, which is arranged on the substrate (10, 23, 28, 30, 34) and is firmly connected to the substrate (10, 23, 28, 30, 34), with which method a curable, elastic and electrically conductive sealing material in pasty form is deposited in an adhesive manner onto the substrate (10, 23, 28, 30, 34) in a defined geometric pattern, and subsequently cured, **characterised in that** a flexible substrate (10, 23, 28, 30, 34) is used, that the substrate (10, 23, 28, 30, 34) is applied on a suitable, stable underlay (11) and is adequately fixed there, that the sealing material is deposited by way of a deposition device (12) which is movable relative to the substrate (10, 23, 28, 30, 34) and which tracks the predefined geometric pattern, in the form of a sealing bead (14, 22, 27, 29, 33) from a nozzle (13) onto the substrate (10, 23, 28, 30, 34) and is cured as a sealing bead (14, 22, 27, 29, 33), and that the finished seal (15,21, 26) is removed from the underlay (11) for the transport, storage and for the direct application.

2. A method according to claim 1, **characterised in that** the sealing bead (14, 22, 27, 29, 33) is composed of several individual beads.

3. A method according to claim 2, **characterised in that** the individual bead of the sealing bead (14, 22, 27, 29, 33) are deposited out of a nozzle, one after the other, onto the substrate (10, 23, 28, 30, 34).

4. A method according to claim 2, **characterised in that** the individual bead of the sealing bead (14, 22, 27, 29, 33) are deposited from several nozzles, simultaneously onto the substrate (10, 23, 28, 30, 34).

5. A method according to one of the claims 1 to 4, **characterised in that** an elastomer mixed with electrically conductive fillers is used as a sealing material.

6. A method according to one of the claims 1 to 5, **characterised in that** the sealing material is deposited onto a full-surfaced substrate (10, 23, 28, 30, 34), and that subsequently the regions covered with the sealing bead (14, 22, 27, 29, 33) are separated out of the full-surfaced substrate, and form the seal (15, 21, 26).

7. A method according to claim 6, **characterised in that** the regions covered with the sealing bead (14, 22, 27, 29, 33) are separated out of the full-surfaced substrate (10, 23, 28, 30, 34) by way of punching.

8. A method according to claim 6, **characterised in that** the regions covered with the sealing bead (14, 22, 27, 29, 33) are separated out of the full-surfaced substrate (10, 23, 28, 30, 34) by way of cutting, in particular laser-cutting or water-jet cutting.

9. A method according to one of the claims 1 to 5, **characterised in that** the regions which are to carry the later sealing bead (14, 22, 27, 29, 33) are separated out of a full-surfaced substrate (10, 23, 28, 30, 34), and that the sealing material is deposited onto the separated-out regions for forming the seal (15, 21, 26).

10. A method according to one of the claims 1 to 9, **characterised in that** a flexible film is used as a substrate (10).

11. A method according to claim 10, **characterised in that** the film is electrically insulating, and in particular consists of a plastic material.

12. A method according to claim 10 , **characterised in that** the film is electrically conductive and in particular is a metal film or a plastic film which is metallised on one or on both sides.

13. A method according to one of the claims 1 to 9, **characterised in that** a fabric, grid or net is used as a substrate (10, 23, 28, 30, 34).

14. A method according to claim 13, **characterised in that** the fabric, grid or net is electrically insulating and in particular consist of a plastic material.

15. A method according to claim 14, **characterised in that** the tissue, grid or net is electrically conductive and in particular is a metal fabric, metal grid or metal net.

16. A method according to one of the claims 1 to 9, **characterised in that** a fiber non-woven is used as a substrate (10).

17. A method according to one of the claims 1 to 16, **characterised in that** a substrate is used, which comprises recesses in the region of the sealing bead (14), through which the sealing bead (14) may come into contact with a surface on which the seal (15) with the substrate (10) lies.

18. A method according to one of the claims 1 to 17, **characterised in that** openings (24, 25) for adjusting and/or fixing the seal (21) on a sealing surface are provided in the substrate (23).

## Revendications

1. Procédé de fabrication d'un joint (15, 21, 26) transportable, constituant un blindage électromagnétique pour une pièce à rendre étanche, lequel joint (15, 21, 26) est stocké et transporté séparément de la pièce à rendre étanche et peut être monté à une date ultérieure sur une surface d'étanchéité de la pièce à rendre étanche, et lequel joint (15, 21, 26) comprend un substrat (10, 23, 28, 30, 34) avec un bourrelet d'étanchéité (14, 22, 27, 29, 33) disposé sur le substrat (10, 23, 28, 30, 34) et solidaire du substrat (10, 23, 28, 30, 34), réalisé dans un matériau élastique électriquement conducteur, selon lequel procédé un matériau d'étanchéité durcissable, élastique et électriquement conducteur se présentant sous forme pâteuse est appliqué selon un motif géométrique prédéfini sur le substrat (10, 23, 28, 30, 34) de manière à y adhérer, et est ensuite durci, **caractérisé en ce que** l'on utilise un substrat (10, 23, 28, 30, 34) flexible, que le substrat (10, 23, 28, 30, 34) est posé sur un support (11) stable approprié et y est suffisamment fixé, que le matériau d'étanchéité est appliqué sur le substrat (10, 23, 28, 30, 34) sous la forme d'un bourrelet d'étanchéité (14, 22, 27, 29, 33) sortant d'une buse (13) au moyen d'un dispositif d'application (12) se déplaçant par rapport au substrat (10, 23, 28, 30, 34) et suivant le motif géométrique prédéfini, et durci en tant que bourrelet d'étanchéité (14, 22, 27, 29, 33), et que le joint (15, 21, 26) fini est prélevé du support (11) pour être transporté, stocké ou directement utilisé.

2. Procédé selon la revendication 1, **caractérisé en ce que** le bourrelet d'étanchéité (14, 22, 27, 29, 33) est composé de plusieurs bourrelets individuels.

3. Procédé selon la revendication 2, **caractérisé en ce que** les bourrelets individuels du bourrelet d'étanchéité (14, 22, 27, 29, 33) sont appliqués les uns après les autres sur le substrat (10, 23, 28, 30, 34) à partir d'une buse.

4. Procédé selon la revendication 2, **caractérisé en ce que** les bourrelets individuels du bourrelet d'étanchéité (14, 22, 27, 29, 33) sont appliqués sur le substrat (10, 23, 28, 30, 34) à partir de plusieurs buses en même temps.

5. Procédé selon l'une des revendications 1 à 4, **caractérisé en ce que** l'on utilise comme matériau d'étanchéité un élastomère mélangé à des matières de charge électriquement conductrices.

6. Procédé selon l'une des revendications 1 à 5, **caractérisé en ce que** le matériau d'étanchéité est appliqué sur un substrat (10, 23, 28, 30, 34) à pleine surface et qu'ensuite les zones couvertes par le bourrelet d'étanchéité (14, 22, 27, 29, 33) sont séparées du substrat (10, 23, 28, 30, 34) à pleine surface et forment le joint (15, 21, 26).

7. Procédé selon la revendication 6, **caractérisé en ce que** les zones couvertes par le bourrelet d'étanchéité (14, 22, 27, 29, 33) sont séparées du substrat (10, 23, 28, 30, 34) à pleine surface par découpage à l'emporte-pièce.

8. Procédé selon la revendication 6, **caractérisé en ce que** les zones couvertes par le bourrelet d'étanchéité (14, 22, 27, 29, 33) sont séparées du substrat (10, 23, 28, 30, 34) à pleine surface par découpage, en particulier découpage au laser ou découpage au jet d'eau.

9. Procédé selon l'une des revendications 1 à 5, **caractérisé en ce que** les zones qui doivent porter le futur bourrelet d'étanchéité (14, 22, 27, 29, 33) sont séparées d'un substrat (10, 23, 28, 30, 34) à pleine surface et que, pour former le joint (15, 21, 26), le matériau d'étanchéité est appliqué sur les zones séparées.

10. Procédé selon l'une des revendications 1 à 9, **caractérisé en ce que** l'on utilise une feuille flexible comme substrat (10).

11. Procédé selon la revendication 10, **caractérisé en ce que** la feuille est électriquement isolante et composée en particulier d'une matière plastique.

12. Procédé selon la revendication 10, **caractérisé en ce que** la feuille est électriquement conductrice et est en particulier une feuille métallique ou une feuille en matière plastique métallisée d'un côté ou des deux côtés.

13. Procédé selon l'une des revendications 1 à 9, **caractérisé en ce que** l'on utilise un tissu, une grille ou un réseau comme substrat (23, 28, 30, 34).

14. Procédé selon la revendication 13, **caractérisé en ce que** le tissu, la grille ou le réseau est électriquement isolant(e) et composé(e) en particulier d'une matière plastique.

15. Procédé selon la revendication 14, **caractérisé en ce que** le tissu, la grille ou le réseau est électriquement conducteur/conductrice et est en particulier un tissu, une grille ou un réseau métallique.

16. Procédé selon l'une des revendications 1 à 9, **caractérisé en ce que** l'on utilise un non-tissé comme substrat (10).

17. Procédé selon l'une des revendications 1 à 16, **caractérisé en ce que** l'on utilise un substrat (10) qui présente dans la région du bourrelet d'étanchéité (14) des évidements (21) à travers lesquels le bourrelet d'étanchéité (14) peut entrer en contact avec une surface sur laquelle le joint (15) repose avec le substrat (10).

18. Procédé selon l'une des revendications 1 à 17, **caractérisé en ce qu'**il est prévu dans le substrat (23) des ouvertures (24, 25) pour ajuster et/ou fixer le joint (21) sur une surface d'étanchéité.
